# EUROPEAN PATENT SPECIFICATION

(11) **EP 0 693 782 B1**
(45) Date of publication and mention of the grant of the patent: **15.11.2000**
(21) Application number: 94305121.9
(22) Date of filing: 13.07.1994
(51) Int. Cl.: H01L 27/02, H01L 23/485

(54) **Method for reducing process antenna effect**
Verfahren zur Reduzierung des Antenneneffekts während der Fabrikation
Procédé pour la réduction de l'effet d'antenne pendant la fabrication

(43) Date of publication of application: 24.01.1996
(73) Proprietor: UNITED MICROELECTRONICS CORPORATION, Science-Based Industrial Park, Hsinchu City (TW)
(72) Inventor: Hsu, Bill, Chu-Pei City, Hsin-Chu County (TW); Ko, Joe, Hsin-Chu (TW)
(74) Representative: Overbury, Richard Douglas

(56) References cited:
- EP-A- 0 291 014
- EP-A- 0 431 490
- EP-A- 0 490 506
- EP-A- 0 631 314
- GB-A- 2 174 543
- US-A- 4 941 028
- PATENT ABSTRACTS OF JAPAN vol. 9, no. 173 (E-329) 18 July 1985 & JP-A-60 045 048 (NIPPON DENKI) 11 March 1985
- PATENT ABSTRACTS OF JAPAN vol. 7, no. 200 (E-196) 3 September 1983 & JP-A-58 098 938 (NIPPON DENKI) 13 June 1983
- PATENT ABSTRACTS OF JAPAN vol. 10, no. 356 (E-459) 29 November 1986 & JP-A-61 154 054 (TOSHIBA) 12 July 1986
- PATENT ABSTRACTS OF JAPAN vol. 10, no. 379 (E-465) 18 December 1986 & JP-A-61 172 362 (SEIKO EPSON) 4 August 1986
- Symp. VLSI Tech. May. '89, pgs. 73-74, Shone et al.
- Principles of CMOS VLSI Design, Weste, pub. Addison-Wesley 1985, p.112-113

## Description

The present invention relates to the manufacture of highly dense integrated circuits, and more particularly to the reduction of electrostatic charge build-up at the device during manufacture during, for example, plasma etching or the like process steps.

In the manufacture of highly dense integrated circuits using Metal Oxide Semiconductor (MOS) technology with multiple metal layers, electrical charge may build up at the device gate oxide during plasma processing. The charge accumulates on floating polysilicon and metal layers electrically connected to the gate oxide. Interconnection metal lines act as an "antenna", amplifying the charging effect and leading to trapped charges at the gate oxide. These trapped charges can cause yield loss and reliability failures.

Workers in the field have verified this problem experimentally. It has been found that the double metal layer technologies worsen the effect by the ratio of the antenna area to the gate oxide area. The worst degradation of gate oxide occurs during oxynitride deposition. However other plasma processing is also believed to lead to trapped charges at the gate oxide.

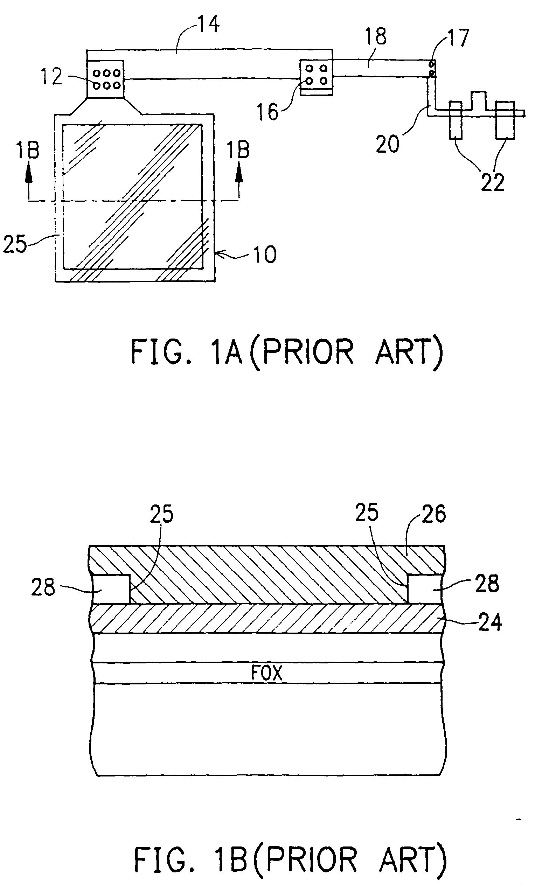

Referring now to Figs. 1A and 1B, there are shown schematic diagrams of a prior process for connecting a large contact pad with an active MOS device by using a metal layer, which could lead to device damage due to the antenna effect. As can be seen in Fig. 1A, in the manufacture of MOS semiconductor devices, a large contact pad area 10 (of typical size 100 by 100 micrometers, and more than about 30 by 30 micrometers) is electrically connected by vias 12 to a polysilicon interconnection 14. The pad area 10 in a double metal process would consist of two layers 24 and 26 of metal, as shown in Fig. 1B. The upper metal layer, or metal II, 26 is connected through an insulating layer 28 to the lower metal layer, or metal I, 24 by a large via 25 which generally has a size less than 5 micrometers smaller than the large contact pad area 10. The polysilicon interconnection 14 is connected, by vias 16 in an insulating layer, to metal interconnection 18. This metal interconnection 18 is connected by vias 17 to polysilicon 20 and thence to active devices 22. There is a direct electrical connection between all elements, and charge accumulated during plasma processing on the polysilicon and large metal areas can lead to damage to the devices due to trapped charges. More specifically, charge will be induced and accumulated on the exposed lower metal layer 24 through the large via 25 in the pre-sputter etching step before the upper metal layer 26 is sputtered. The induced charge can lead to damage to the devices 22 via the direct electrical connection path comprising the lower metal layer 24, the polysilicon interconnection 14, the metal interconnection 18 and the polysilicon 20. In addition, the greater the size of the large via 25, the greater the amount of the charge induced and accumulated.

It is common in the manufacture of integrated circuits today to use plasma etching, plasma enhanced chemical vapor deposition, and sputtering technologies. See VLSI Technology, S. M. Sze., Chapter 5 - Reactive Plasma Etching pages 184-189, Chapter 6 - Dielectric and Polysilicon Film Deposition pages 235-238, Chapter 9 - Metallization pages 386-391, published by McGraw-Hill International Editions 1988 in Singapore. A plasma is a collection of charged particles, including electrons and positive and negative ions, and it is these charged particles that collect along the conductive surfaces during plasma processing, and may produce the trapped charges damaging the gate oxide.

It is a primary object of the present invention to provide a method that will reduce the charge that may accumulate at the gate oxide by reducing the area of the metal exposed during plasma processing.

In Symp. VLSI Tech May 89, p73-74, Shone et al describe techniques for eliminating gate oxide charging. These techniques include subjecting the wafers to longer alloy cycles, depositing a thin dielectric layer on the wafer before oxynitride deposition, and attaching a substrate diode to the antenna. There is no suggestion to reduce gate oxide charging by reducing the exposed metal area. Moreover there is no disclosure of contact pads at the device periphery.

GB-A-2174543 describes a package containing a semiconductor or integrated circuit chip having enlarged electrodes for soldering to bent electrically conductive leads so as to improve the reliability of the electrical connection. There is no teaching as to the elimination of the antenna effect.

"Principles of CMOS VLSI Design" by N. Weste, Addison-Wesley 1985, pages 112-113, discloses a CMOS IC made by a double-level metal process and having contact pad areas at the periphery of an interconnection.

EP-A-0 631 314 constitutes prior art for the present application under Article 54(3) EPC only. It discloses a similar double-metal structure to that achieved by the present invention, except that there is no disclosure of a silicon substrate, and in this prior art a passivation film covers the openings by which the upper and lower metal layers are connected.

In accordance with the present invention, there is provided a method of reducing charge build up at the gate of an MOS device during processing in a plasma environment which is such as would normally produce charge build-up at the gate oxide which method comprises: forming a lower metal layer on a substrate; forming an insulating layer over the lower metal layer; and forming an upper metal layer over the lower metal layer such that the upper metal layer electrically connects to the lower metal layer through at least one opening in the insulating layer; characterised in that: the substrate is a silicon substrate; the upper metal layer constitutes a plurality of large contact pad areas for interconnection to an integrated circuit in the silicon substrate via the lower metal layer, each lower contact pad area being electrically connected to the lower metal layer via a plurality of said openings, and reduction of charge build-up at the gate oxide of the integrated circuit being achieved by reducing the area of the lower metal layer exposed through said openings; and in that a passivation layer is formed over the upper metal layer so as to leave exposed the part of the upper metal layer over said openings.

In accordance with one embodiment of the present invention, an area of the lower metal layer to which each contact pad area is connected, is much smaller than the large contact pad area in order to further reduce the charge build-up at the gate oxide of the integrated circuit. In this case the area of the lower metal layer is about 6 x 100 micrometers, and the size of the large contact pad area is about 80 x 80 to 200 x 200 micrometers.

In accordance with another embodiment of the present invention, the lower metal layer is a first metal layer and a second metal layer is formed so as to be the same size as the first metal layer so that the small second metal layer reduces the charge build-up; a second insulating layer is formed over the second metal layer; and a plurality of openings is formed to the second metal layer in the second insulating layer. A third layer of metal, i.e. the upper metal layer, is formed to constitute the large contact pad areas, such that the third metal layer electrically connects to the second metal layer, through the openings in the second insulating layer; and the passivation layer is formed over the third metal layer. Additional metal layers may be formed in a similar way.

In accordance with a further embodiment of the present invention, the lower metal layer is a second metal layer and the upper metal layer is a third metal layer. In this case the method comprises the steps of forming a second insulating layer over the second metal layer; forming a plurality of openings to the second metal layer, through the second insulating layer; further processing in a plasma environment that would normally produce a charge build-up at the gate oxide of the integrated circuit, but wherein the charge build-up is reduced by having reduced the exposed area of the second metal layer; forming the third layer of metal to constitute the large contact pad areas, such that the third metal layer electrically connects to the second metal layer through the openings in the second insulating layer; and forming the passivation layer over the third metal layer. Additional metal layers may be formed in a similar way.

The large contact pad areas are located at the periphery of the integrated circuit and the processing in the plasma environment includes plasma enhanced chemical vapor deposition, plasma etching or sputter etch.

For a better understanding of the present invention and to show how the same may be carried into effect, reference will now be made by way of example to the accompanying drawings, in which:-
Figs. 1A and 1B illustrate a prior process for connecting a large contact pad with an active MOS device by using a metal layer, which could lead to device damage due to the antenna effect,
Figs. 2A and 2B illustrate the method of the present invention for reducing the antenna effect in a double metal structure by using six small size vias between the first and second metal layers,
Figs. 3A to 3C illustrate a further embodiment of the present invention in a double metal structure which reduces the antenna effect by using a much reduced contact pad area for the first metal layer, and
Fig. 4 illustrates a further embodiment of the present invention, for a triple metal structure.

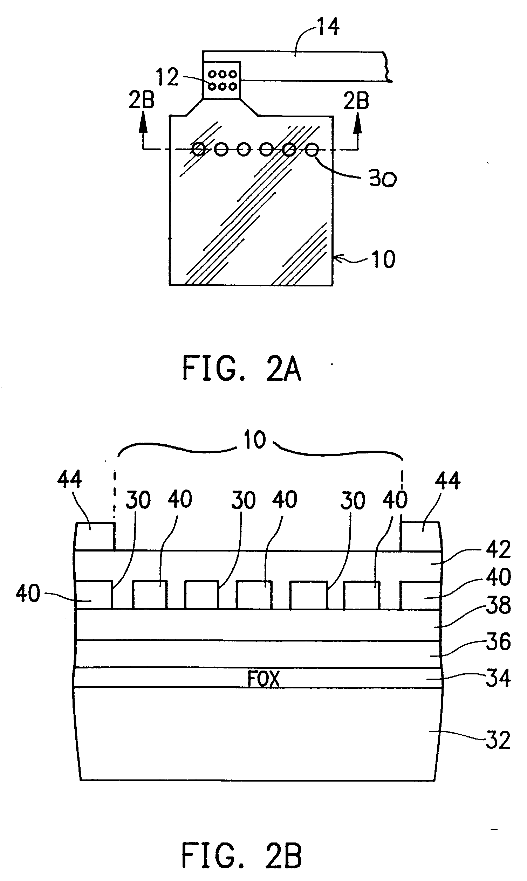

Referring now to Fig. 2A, there is shown the preferred embodiment of the present invention. This embodiment is very similar to that of Fig. 1A. The only difference is that the present invention substitutes six small vias 30 for the single large via 25 of Fig. 1A. The small vias 30 expose a smaller area of lower metal I than the large via 25 does. The reduced area of exposed lower metal I lessens any charge accumulated during plasma processing. In this embodiment, the size of the vias 30 is about 2 x 2 micrometers. However, it should be understood that the number and size of the vias 30 are not intended to be limited to those described above. According to the present invention, the antenna effect can be effectively reduced so long as the exposed area of metal I is effectively decreased.

Referring now to Fig. 2B, there is shown a cross-sectional representation of the embodiment shown in Fig. 2A. Field oxide (FOX) 34 is thermally grown on substrate 32, and a BPSG (Borophosilicate glass) insulating layer 36 is deposited on FOX 34. First metal layer 38 is deposited and patterned, and then another insulating layer 40 is formed. Vias 30 are opened by lithography and etching through the insulating layer 40. The size of the vias 30 is effectively decreased to minimize charge accumulation during plasma processing steps, so that the antenna effect is effectively reduced. Second metal layer 42 is then deposited and connected to the first metal layer 38. Passivation layer 44 is deposited over the second metal layer 42.

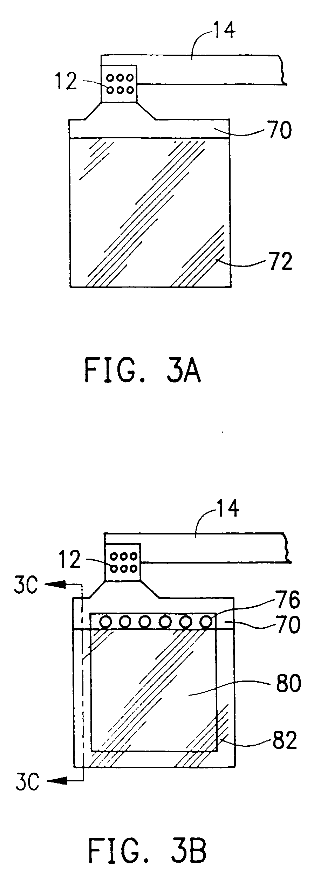

Referring now to Fig. 3A, there is shown a further embodiment of the present invention. First metal layer 70 is deposited and patterned by conventional lithography and etching to cover a much smaller area than the eventual large contact pad area 72. The actual typical dimension of the much smaller area is about 6 x 100 micrometers, whereas the dimension of the larger contact pad area is between about 80 x 80 and 200 x 200 micrometers. The reduced area of metal 70 will further lessen any charge accumulated thereon during subsequent plasma processing. As in the prior art, the first metal layer 70 is connected to the polysilicon interconnection 14 through the vias 12.

Referring now to Fig. 3B, second metal layer 80 is formed and connected to the first metal layer 70 through some small size vias 76, in order to reduce the sputter etch damage before metal 80 sputtering. The via size is, for example, about 2 x 2 micrometers. Passivation layer 82 is formed on top of second metal layer 80, around the perimeter of the contact pad.

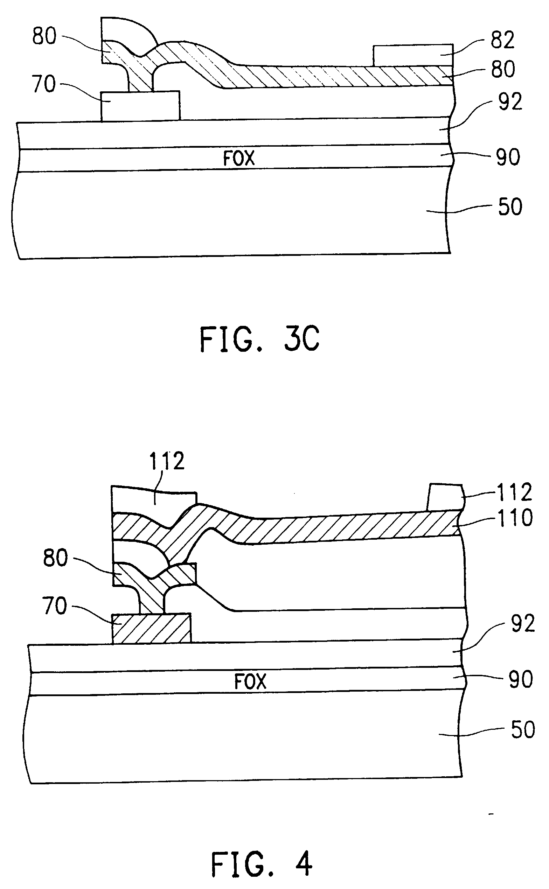

Referring now to Fig. 3C, there is shown a cross-sectional representation of the embodiment shown in Fig. 3B. Field oxide 90 is thermally grown on substrate 50, and BPSG insulating layer 92 is deposited on FOX 90. First metal layer 70 is deposited and patterned to be a much reduced area compared to the large contact pad area. This smaller area minimises charge accumulation during subsequent plasma processing steps. Second metal layer 80 is deposited and connected to the first metal layer 70, and comprises the complete pad area which is much larger than metal 70. Passivation layer 82 is deposited over the second metal layer 80.

Referring now to Fig. 4, there is shown a cross-sectional representation of the formation of a contact pad in a three-metal technology. Field oxide 90 is grown on substrate 50, and BPSG insulating layer 92 is deposited on FOX 90. First metal layer 70 is deposited so as to have a much reduced area compared to the large contact pad area. This smaller area minimises charge accumulation during subsequent plasma processing steps. Second metal layer 80 is deposited and patterned to be the same size as the first metal layer 70, and is connected to the first metal layer 70. Further plasma processing may take place with minimal charge accumulation. Third metal layer 110 is deposited and connected to the second metal layer 80, and comprises the complete pad area. Passivation layer 112 is deposited over the third metal layer 110.

## Claims

1. A method of reducing charge build up at the gate of an MOS device during processing in a plasma environment which is such as would normally produce charge build-up at the gate oxide which method comprises:
forming a lower metal layer (38,70) on a substrate (32,50);
forming an insulating layer (40) over the lower metal layer; and
forming an upper metal layer (42,80) over the lower metal layer such that the upper metal layer electrically connects to the lower metal layer through at least one opening (30,76) in the insulating layer;
characterised in that:
the substrate is a silicon substrate;
the upper metal layer constitutes a plurality of large contact pad areas (72,110) for interconnection to an integrated circuit in the silicon substrate via the lower metal layer (38,70), each contact pad area being electrically connected to the lower metal layer (38,70) via a plurality of said openings (30,76), and reduction of charge build-up at the gate oxide of the integrated circuit being achieved by reducing the area of the lower metal layer (38,70) exposed through said openings; and in that
a passivation layer (44,82) is formed over the upper metal layer so as to leave exposed the part of the upper metal layer over said openings.

2. The method as claimed in claim 1, wherein an area of the lower metal layer to which each contact pad area is connected, is much smaller than the large contact pad area in order to further reduce the charge build-up at the gate oxide of the integrated circuit.

3. The method as claimed in claim 2, wherein said area of the lower metal layer is about 6 x 100 micrometers.

4. The method as claimed in any of the preceding claims, wherein the size of each large contact pad area is from about 80 x 80 to about 200 x 200 micrometers.

5. The method as claimed in any preceding claim, wherein the processing in the plasma environment is plasma enhanced chemical vapor deposition.

6. The method as claimed in any of claims 1 to 4, wherein the processing in the plasma environment is plasma etching.

7. The method as claimed in claim 6, wherein the plasma etching is a sputter etch.

8. The method as claimed in claim 2, wherein said lower metal layer is a first metal layer (70), the method comprising the steps of
forming a second metal layer (80) having the same size as the first metal layer;
further processing in a plasma environment that would normally produce charge build-up at the gate oxide of the integrated circuit, but wherein the small second metal layer reduces the charge build up;
forming a second insulating layer over the second metal layer;
forming a plurality of openings to the second metal layer through the second insulating layer;
forming a third layer (110) of metal to form the large contact pad areas, such that the third metal layer electrically connects to the second metal layer through the openings in the second insulating layer; and
forming the passivation layer (112) over the third metal layer.

9. The method as claimed in any one of claims 1 to 7, wherein the lower metal layer is a second metal layer, and the upper metal layer is a third metal layer.

## Patentansprüche

1. Verfahren zur Verringerung der elektrostatischen Aufladung am Gate einer MOS-Vorrichtung bei der Verarbeitung in einer Plasmaumgebung, die derart ist, dass sich das Gateoxid gewöhnlich auf lädt, umfassend:
das Aufbringen einer unteren Metalischicht (38, 70) auf ein Substrat (32, 50);
das Aufbringen einer Isolationsschicht (40) auf die untere Metalischicht; und
das Aufbringen einer oberen Metalischicht (42, 80) auf die untere Metallschicht, so dass die obere Metallschicht über mindestens eine Öffnung (30, 76) in der Isolationsschicht mit der unteren Metallschicht leitend verbunden ist;
dadurch gekennzeichnet, dass:
das Substrat ein Siliciumsubstrat ist,
die obere Metalischicht viele große Kontaktanschlussflächen (72, 110) für die Zusammenschaltung mit einem integrierten Schaltkreis im Siliciumsubstrat über die untere Metallschicht (38, 70) ausbildet, wobei die Kontaktanschlussflächen jeweils über viele Öffnungen (30, 76) mit der unteren Metalischicht leitend verbunden sind und eine Aufladung am Gateoxid des integrierten Schaltkreises verringert wird, indem die durch die Öffnungen frei bleibende Fläche der unteren Metallschicht (38, 70) verkleinert wird; und
eine Passivierungsschicht (44, 82) derart auf die obere Metallschicht aufgebracht wird, dass der Bereich der oberen Metalischicht über den Öffnungen frei bleibt.

2. Verfahren nach Anspruch 1, wobei eine Fläche der unteren Metalischicht, mit der die Kontaktanschlussflächen jeweils verbunden sind, viel kleiner als die große Kontaktanschlussfläche ist, damit die Aufladung am Gateoxid des integrierten Schaltkreises weiter reduziert wird.

3. Verfahren nach Anspruch 2, wobei die Fläche der unteren Metallschicht etwa 6 x 100 µm beträgt.

4. Verfahren nach einem der vorhergehenden Ansprüche, wobei die Größe der großen Kontaktanschlussflächen jeweils etwa 80 x 80 bis etwa 200 x 200 µm beträgt.

5. Verfahren nach einem vorhergehenden Anspruch, wobei die Verarbeitung in der Plasmaumgebung eine plasmaunterstützte chemische Gasphasenabscheidung ist.

6. Verfahren nach einem der Ansprüche 1 bis 4, wobei die Verarbeitung in der Plasmaumgebung Plasma-Ätzen ist.

7. Verfahren nach Anspruch 6, wobei das Plasma-Ätzen Sputter-Ätzen ist.

8. Verfahren nach Anspruch 2, wobei die untere Metallschicht eine erste Metallschicht (70) ist, umfassend die Schritte:
Aufbringen einer zweiten Metalischicht (80), die genau so groß wie die erste Metalischicht ist;
weiteres Verarbeiten in einer Plasmaumgebung, in der sich das Gateoxid des integrierten Schaltkreises gewöhnlich auflädt, wobei jedoch die kleine zweite Metalischicht die Aufladung verringert;
Aufbringen einer zweiten Isolationsschicht auf der zweiten Metalischicht;
Herstellen vieler Öffnungen in der zweiten Isolationsschicht zur zweiten Metallschicht;
Aufbringen einer dritten Metallschicht (110), die die großen Kontaktanschlussflächen ausbildet, so dass die dritte Metalischicht über die Öffnungen in der zweiten Isolationsschicht mit der zweiten Metalischicht leitend verbunden ist; und
Aufbringen der Passivierungsschicht (112) auf die dritte Metallschicht.

9. Verfahren nach einem der Ansprüche 1 bis 7, wobei die untere Metalischicht eine zweite Metallschicht ist, und die obere Metallschicht eine dritte Metallschicht ist.

## Revendications

1. Procédé pour réduire la charge qui s'accumule sur la grille d'un dispositif MOS pendant son traitement dans un environnement de plasma, qui est tel qu'il produirait normalement une accumulation de charges au niveau de l'oxyde de grille, lequel procédé consiste à :
former une couche métallique inférieure (38,70) sur un substrat (32,50);
former une couche isolante (40) sur la couche métallique inférieure; et
former une couche métallique supérieure (42,80) sur la couche métallique inférieure de telle sorte que la couche métallique supérieure connecte électriquement la couche métallique inférieure par l'intermédiaire d'au moins une ouverture (30,76) formée dans la couche isolante;
caractérisé en ce que :
le substrat est un substrat en silicium;
la couche métallique supérieure est constituée par une pluralité de zones étendues formant plot de contact (72,110) pour l'interconnexion à un circuit intégré dans le substrat en silicium par l'intermédiaire de la couche métallique inférieure (38,70), chaque zone de plot de contact étant connectée électriquement à la couche métallique inférieure (38,70) par l'intermédiaire d'une pluralité desdites ouvertures (30,76), et une réduction de l'accumulation de charges au niveau de l'oxyde de grille du circuit intégré étant obtenue par réduction de la surface de la couche métallique inférieure (38,70) exposée par lesdites ouvertures; et en ce
qu'une couche de passivation (44,82) est formée au-dessus de la couche métallique supérieure de manière à laisser exposée la partie de la couche métallique supérieure située au-dessus desdites ouvertures.

2. Procédé selon la revendication 1, selon lequel une zone de la couche métallique inférieure, à laquelle est connectée chaque zone de plot de contact, est beaucoup plus petite que la zone étendue de plot de contact, de manière à réduire de façon supplémentaire l'accumulation de charges au niveau de l'oxyde de grille du circuit intégré.

3. Procédé selon la revendication 2, selon lequel ladite surface de la couche métallique inférieure est égale à environ 6 x 100 micromètres.

4. Procédé selon l'une quelconque des revendications précédentes, selon lequel les dimensions de chaque zone étendue de plot de contact sont comprises entre environ 80 x 80 et environ 200 x 200 micromètres.

5. Procédé selon l'une quelconque des revendications précédentes, selon lequel le traitement dans l'environnement de plasma est un dépôt chimique en phase vapeur intensifié par plasma.

6. Procédé selon l'une quelconque des revendications 1 à 4, selon lequel le traitement dans l'environnement de plasma est une corrosion plasmatique.

7. Procédé selon la revendication 6, selon lequel la corrosion plasmatique est une corrosion par pulvérisation.

8. Procédé selon la revendication 2, selon lequel ladite couche métallique inférieure est une première couche métallique (70), le procédé comprenant les étapes consistant à :
former une seconde couche métallique (80) possédant les mêmes dimensions que la première couche métallique;
continuer le traitement dans un environnement de plasma qui normalement produirait une accumulation de charges au niveau de l'oxyde de grille du circuit intégré, mais lors duquel la petite seconde couche métallique réduit l'accumulation de charges;
former une seconde couche isolante sur la seconde couche métallique;
aménager une pluralité d'ouvertures aboutissant à la seconde couche métallique, à travers la seconde couche isolante;
former une troisième couche (110) réalisée en un métal de manière à former les zones étendues de plots de contact, de telle sorte que la troisième couche métallique connecte électriquement la seconde couche métallique à travers les ouvertures formées dans la seconde couche isolante; et
former la couche de passivation (112) dans la troisième couche métallique.

9. Procédé selon l'une quelconque des revendications 1 à 7, selon lequel la couche métallique inférieure est une seconde couche métallique, et la couche métallique supérieure est une troisième couche métallique.
